# EUROPEAN PATENT APPLICATION

(11) **EP 0 867 941 A2**
(43) Date of publication of application: **30.09.1998**
(21) Application number: 98302378.9
(22) Date of filing: 27.03.1998
(51) Int. Cl.: H01L 23/532

(54) **An interconnect structure for use in an intergrated circuit**

(30) Priority: 28.03.1997 US 825360
(71) Applicant: Applied Materials, Inc., Santa Clara, California 95054 (US)
(72) Inventor: Liao, Marvin, Singapore 799018 (CN); Chern, Chyi, Saratoga, California 95070 (US); Tseng, Jennifer, Saratoga, California 95070 (US); Danek, Michal, Sunnyvale, California 94087 (US); Mosely, Roderick C., Pleasanton, California 94588 (US); Littau, Karl, Palo Alto, California 94303 (US); Raaijmakers, Ivo, Phoenix, Arizona 85048 (US)
(74) Representative: Allard, Susan Joyce

(57) **Abstract**

A structure is formed in an integrated circuit to provide for the coupling of elements in the integrated circuit. The structure extends form a conductive surface through a channel extending above the conductive surface. The structure includes a layer of a refractory metal, a layer of a metal nitride, and a layer of a metal. The layer of the refractory metal is deposited on the conductive surface and inner walls of the channel. The layer of the metal nitride is formed on the layer of the refractory metal. The layer of the metal nitride has a thickness extending from the layer of the refractory metal of less than 130 Å. The layer of the metal is deposited on the layer of the metal nitride.

## Description

The present invention is directed toward the field of manufacturing integrated circuits.

An integrated circuit is manufactured through a series of process steps in which circuit elements, such as transistors, are formed in a substrate and then coupled to other circuit elements. Circuit elements are coupled together through a metalization process. In order to provide for all the necessary coupling, multiple metalization steps may be employed to create several layers of electrical interconnections within a single integrated circuit.

The need for multiple metal layers in integrated circuits has arisen from the on going shrinking of dimensions in integrated circuits. The shrinking dimensions provide for the integration of more circuit elements in smaller surface areas. As a result of the increased number of circuit elements and decreased surface area, the interconnections must be distributed over multiple integrated circuit layers.

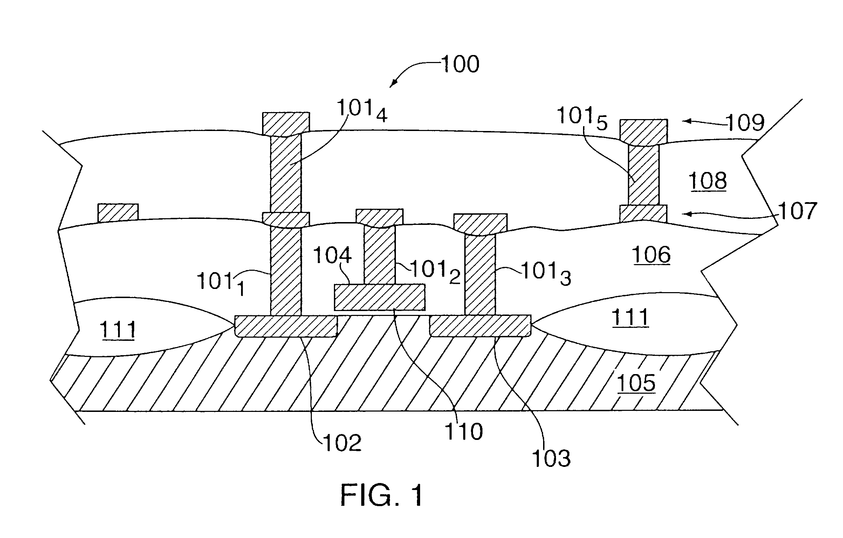

Fig. 1 illustrates a cross-sectional view of a portion of an integrated circuit 100 that includes multiple metal layers 107, 109. A transistor is shown having a source 102 and drain 103 formed in a substrate 105. The transistor's gate 104 has been deposited and patterned on a gate oxide 110, which separates the gate from the substrate 105. A layer of insulative material 106, such as silicon dioxide, is deposited over the upper surface of the gate 104, the substrate 105, and a field oxide 111. The insulative material 106 isolates regions of the gate 104 and substrate 105 from a first metal layer 107. Another layer of insulative material 108 isolates the first metal layer 107 from a second metal layer 109.

Interconnect structures provide for conductively coupling regions within the integrated circuit 100. For example, interconnect structures 101₁-101₃ couple the source 102, gate 104, and drain 103, respectively, to the first metal layer 107, and interconnect structures 101₄ and 101₅ couple metal lines in the first metal layer 107 to the second metal layer 109. Each interconnect structure 101₁-101₅ is formed in a channel that is etched through an insulative layer of material to expose an underlying conductive region, such as source 102, drain 103, gate 104, and metal layer 107.

In order for an interconnect structure in an integrated circuit to operate effectively, it must provide a good ohmic contact between the underlying surface and overlying surface that it is coupling together. Otherwise, the current flow between circuit elements in the integrated circuit will be greatly restricted. As a result, the speed of the integrated circuit will be greatly reduced. In the worst case, the integrated circuit may be rendered inoperable. It is acceptable for an interconnect structure to have a resistance of approximately 3 Ω or less for a contact hole or via hole with a 0.3 µm width. Interconnect structures that have resistance values in excess of 3 Q are generally not acceptable.

In forming an interconnect structure, a metal component may be stacked on top of a conductive barrier layer within a channel that is formed in an insulative layer of material. The channel is often referred to as a contact hole or via hole. The barrier layer is formed on the inner walls of the channel and an underlying surface that is surrounded by the channel. Traditionally, barrier layers have thicknesses in the range of 400-500 Å.

The barrier layer inhibits the diffusion of the metal in the metal component and by-products generated during the deposition of the metal into the surface underlying the interconnect structure. If such diffusion is not prevented, highly resistive pockets may be formed in the region underlying the interconnect structure. As a result of the diffusion, the integrated circuit being formed may be defective. Barrier layer thicknesses of 400-500 Å have traditionally been employed, because such thicknesses have proven effective for inhibiting the undesirable diffusion of an interconnect structure's metal into an underlying surface.

Once the barrier layer is formed, the metal material being used in the interconnect structure is deposited to cover the upper surface of the barrier layer. Ideally, the metal fills the channel in which the barrier layer resides. Next, the upper surface of the integrated circuit is isotropically etched to remove any metal and barrier layer material that was deposited on the upper surface of the integrated circuit.

Once a set of interconnect structures has been formed in a layer of insulative material, a layer of metal may be deposited on the upper surface of the insulative material. The metal is then patterned to form a set of metal lines in a metal layer. These metal lines provide for electrically coupling together sets of interconnect structures.

The reduction in the dimensions of integrated circuits has presented challenges to the construction of interconnect structures with acceptable resistance values. When the gate lengths in an integrated circuit are reduced, the width of the channels serving as contact and via holes in the integrated circuit is also reduced. However, the height of the channels is typically not reduced. This causes the ratio of a channel's height to the channel's width to increase when the dimensions of the integrated circuit are reduced. This ratio is referred to as an aspect ratio.

As a result of such a change in channel shape, interconnect structures become narrower, while maintaining approximately the same height as in integrated circuits with larger dimensions. Traditionally, the thickness of barrier layers has remained at 400-500 Å, even in integrated circuits with reduced dimensions. On the other hand, the width of interconnect structure metal components has been reduced to account for increases in channel aspect ratios.

The narrowing of a metal component's width in response to increasing aspect ratios causes the resistance of the metal component to increase. Further, the difficulty of conformally depositing metal over a barrier layer is increased in smaller dimension integrated circuits by the combination of the smaller channel opening and thick barrier layer. This is critical, since poorly conformed metal can further increase the resistance of the interconnect structure.

The constant desire to reduce the cost of manufacturing integrated circuits and increase the speed of integrated circuits is causing a demand for integrated circuits with gate lengths of .25 µm and less. In such integrated circuits, contact and via holes may have widths of approximately 3,000 Å or less. The implementation of traditional 400-500 Å barrier layers in such contact and via holes results in interconnect structure metal components with very narrow widths and poor conformality. In fact, the application of a 500 Å barrier layer in a 1,000 Å wide channel may result in no volume of the interconnect structure being available to house a metal component.

Interconnect structures that are formed using traditional 400-500 Å barrier layers in integrated circuits with gate lengths of .25 µm and less have been found to have resistance values in the range of 4-5 Ω. Such resistance values are unacceptable. They cause the speed enhancements provided by the reduced dimension technology to be negated and the reliability of the reduced dimension integrated circuits to be decreased.

Accordingly, it is desirable to provide for the construction of an interconnect structure with a thin barrier layer that can be employed in contact and via holes with increased aspect ratios, so that the resistance of the interconnect structure is not unacceptably high.

An interconnect structure that is formed in accordance with the present invention has the ability to be employed in contact and via holes having increased aspect ratios, without having unacceptable resistance values. Such an interconnect structure is formed to extend from a conductive surface in an integrated circuit through a channel extending above the surface. The channel is typically formed in an insulative layer of material, such as silicon dioxide.

The interconnect structure includes a barrier layer and a metal component. The barrier layer covers the conductive surface and the inner walls of the channel. The metal component resides on top of the barrier layer to provide a conductive surface that may be coupled to a metal layer within the integrated circuit.

The barrier layer is formed by the combination of a layer of a refractory metal and a layer of a metal nitride. The layer of the refractory metal is deposited on the underlying conductive surface and the inner walls of the channel. The refractory metal makes a highly conductive contact with the underlying conductive surface.

The layer of a metal nitride is then formed on the layer of the refractory metal. The layer of metal nitride has a thickness extending from the layer of the refractory metal of less than 130 Å. As a result, there is sufficient width remaining in the channel for forming the metal component, so that the interconnect structure has an acceptable resistance value. The metal nitride makes an adhesive conductive connection with the metal component to provide an interconnect structure with good electrical and structural integrity. The layer of the metal nitride may be formed by depositing metal nitride and then plasma annealing the metal nitride to reduce its resistivity.

Once the barrier layer is formed, a layer of metal is deposited on the barrier layer. The layer of metal forms the metal component of the interconnect structure. Tungsten may be employed as the metal.

Further details of the present invention are explained with the help of the attached drawings, provided by way of example, in which:

Fig. 1 illustrates a cross-sectional view of a portion of an integrated circuit which includes multiple metal layers.

Figs. 2(a)-2(g) are partial cross-sectional views of a portion of an integrated circuit which illustrate the formation of an interconnect structure in accordance with the present invention.

Fig. 3 illustrates a chamber that may be employed to form the layer of metal nitride in the barrier layer of the interconnect structure, as shown in Figs. 2(c) and 2(d).

In accordance with the present invention, an interconnect structure may be formed to have a metal component that conforms to an underlying barrier layer. The metal component also has a sufficiently large width, so that the interconnect structure has an acceptable resistance value. Such an interconnect structure may be employed in an integrated circuit with gate lengths of .25 µm and less without unacceptably decreasing the speed of the integrated circuit's operation or providing an unacceptable risk of harmful diffusion.

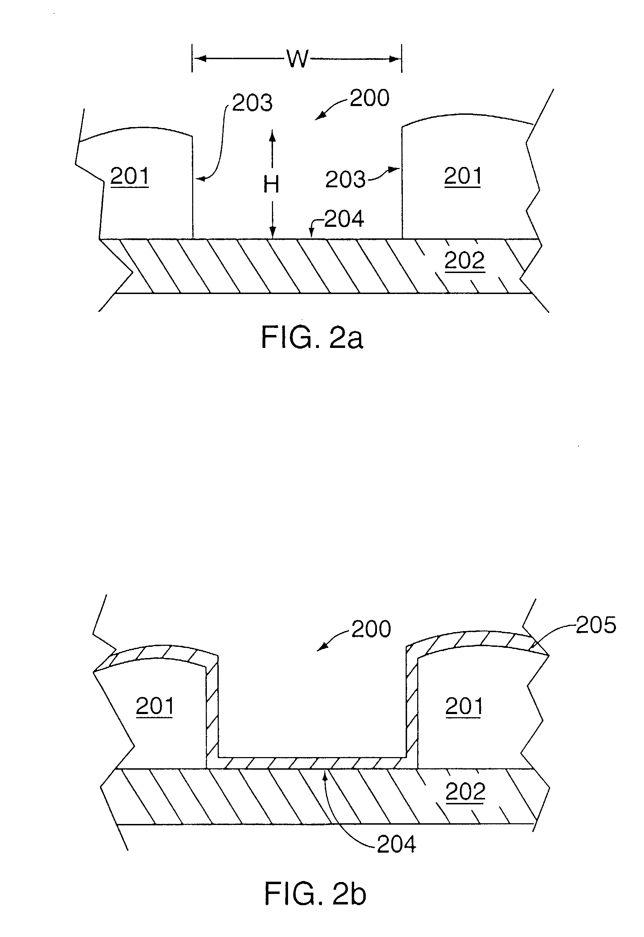

Figs. 2(a)-2(g) illustrate the formation of an interconnect structure in accordance with the present invention. Fig. 2(a) illustrates a cross-sectional view of a channel 200, such as a contact hole or via hole, that is formed in an integrated circuit. The channel 200 is formed in a layer of insulative material 201, such as silicon dioxide or another type of oxide. The insulative material 201 extends upward from an upper surface of a conductive material 202 for a distance of H.

The conductive material 202 may be a gate, a source, a drain, a metal line, or another conductive element that is to be conductively coupled to another component within the integrated circuit. The conductive material may be composed of silicon, polyslicon, polyside, silicide, aluminum, copper, or another conductive material that is employed within integrated circuits.

The inner walls 203 of the channel 200 surround a contact surface 204 of the conductive material 202. The channel 200 has a width of W, which is measured across the diameter of channel 200. Accordingly, the aspect ratio of the channel is calculated by dividing the height H by the width W. For example, in an integrated circuit that is manufactured using gate lengths of .25 µm or less, the width W may be 3,000 Å, and the height H may be 10,000 Å. This results in an aspect ratio of 3.33 for the channel 200.

In order to form am interconnect structure within the channel 200, a barrier layer is formed over the upper surface of the insulative material 201 and the exposed contact surface 204. The barrier layer may be formed by first depositing a layer of a first material that has good conductive properties when reacted with the exposed conductive material 202.

Next, a layer of a second material is formed over the first material. The second material provides for creating an adhesive conductive contact with the metal component of the interconnect structure. The second material also inhibits the diffusion of damaging material into the first material and underlying conductive material. When depositing metal to form the metal component, such damaging material is provided by the metal being deposited and by-products of the metal. The combination of the first material and the second material constitutes the barrier layer.

Fig. 2(b) illustrates the deposition of the layer of the first material 205 in the barrier layer. In accordance with the present invention, the first material 205 in the barrier layer is deposited over the surface of the insulative material 201, including the inner walls 203 of the channel 200, and the exposed contact surface 204 of the conductive material 202. In one embodiment, the deposited layer of the first material 205 has a thickness of less than 300 Å when measured from the top corners of the channel's inner walls 203. In a further embodiment, the first layer of material has a thickness extending from the channel's inner walls 203 in the range of 25 Å to 100 Å, depending on the deposition process that is employed.

The first material 205 may be a refractory metal, such as titanium, cobalt, tantalum, and molybdenum. When the first material 205 is a refractory metal and the underlying conductive material 202 is silicon or polysilicon which is heated, a silicide of the refractory metal forms at the -surface 204 of the conductive material 202. Refractory metals are desirable for use as the first material 205, because they provide highly conductive contacts with silicon based materials, which often make up the underlying conductive material 202. However, refractory metals may also be employed when the underlying conductive material 202 is not silicon based, such as when the conductive material 202 is an aluminum or copper metal line.

The first material 205 in the barrier layer may be deposited using a traditional deposition technique, such as chemical vapor deposition ("CVD") or physical vapor deposition ("PVD"). In a CVD process, a wafer is loaded into a chemical vapor deposition chamber. Reactive gases are then supplied to the wafer surface where heat-induced chemical reactions take place to form a thin film layer over the surface of the wafer being processed.

In a PVD process, a wafer is placed in a physical vapor deposition chamber, and the chamber is filled with a gas, such as argon. A plasma containing positively charged ions is generated from the gas, by creating an electrical field in the chamber. The positively charged ions accelerate and collide into a target material, which is mounted in the chamber. Atoms of the target material are thereby dislodged from the target and deposited on the wafer to form a layer of target material on the surface of the wafer.

A separate rf signal may be inductively coupled to the chamber for generating positively charged ions in a high density plasma PVD chamber. A high density plasma PVD chamber may include yet another rf signal coupled to a wafer support for improving the attraction of the target material to the wafer.

Two commercially available PVD processes that may be employed to deposit a refractory metal 205 for a barrier layer in accordance with the present invention are the Coherent process and the Vectra IMP process, where IMP stands for Ionized Metallic Plasma. Both the Coherent process and Vectra IMP process are provided by Applied Materials, Inc. of Santa Clara, California along with PVD chambers for performing these processes.

A chamber for performing the Coherent process includes a target that is DC biased, and a wafer support that is grounded. As described above, an argon gas is provided in the chamber and infused with voltage between the target and wafer support to form a plasma. In the Coherent deposition process, a DC energy is provided to the target with a power in the range of 8,000 to 20,000 watts. The temperature of the wafer is set to be in the range of 200 to 300 °C, and the pressure in the chamber is set to be in the range of 3 to 10 mTorr.

In order to guide the path of the target material that is dislodged from the target, the Coherent process chamber includes a collimator. The collimator is a metallic disc that is supported in the chamber between the target and the wafer support to be substantially parallel to the upper surface of the wafer support. Hollow columns extend through the disc and are substantially perpendicular to the upper surface of the wafer support. The hollow columns serve as guides for the target material that is being deposited.

As dislodged target material reaches the columnator, the target material that is following a trajectory which is substantially perpendicular to the wafer support passes through the hollow columns. The other target material is blocked. This inhibit the excessive build up of target material at the openings of contact holes and via holes in the wafer's surface. By only allowing the perpendicularly directed target material to be passed to the wafer, a more even and conformal layer of target material is deposited.

A chamber for performing the Vectra IMP process includes a target that is DC biased, and a wafer support that is coupled to an rf signal generator. The chamber further includes a coil circling the inside of the chamber. The coil is coupled to another rf signal generator.

Argon gas is flowed into the chamber and is infused with energy to form a plasma. In the Vectra IMP deposition process, the rf energy is provided by the rf signal source that is coupled to the wafer support and the rf signal source that is coupled to the coil. The rf signal being provided to the wafer support has a frequency in the range of 300 to 450 KHz and a power in the range of 100 to 1,000 watts. The rf signal being provided to the coil has a frequency in the range of 1 to 5 MHz and a power in the range of 1,000 to 4,000 watts. The temperature of the wafer is set to be in the range of 100 to 300 °C, and the pressure in the chamber is set to be in the range of 10 to 40 mTorr. The wafer obtains a DC bias voltage in the range of 50 to 200 volts.

The rf signal being provided to the coil provides an electric field in the chamber that ionizes the dislodged target material. The voltage potential between the ionized target material and the wafer causes the target material to be attracted to the wafer's surface. As a result, the target material tends to impact the surface of the wafer with a relatively perpendicular trajectory with respect to the wafer. This provides for a conformal layer of the first material 205 to be deposited.

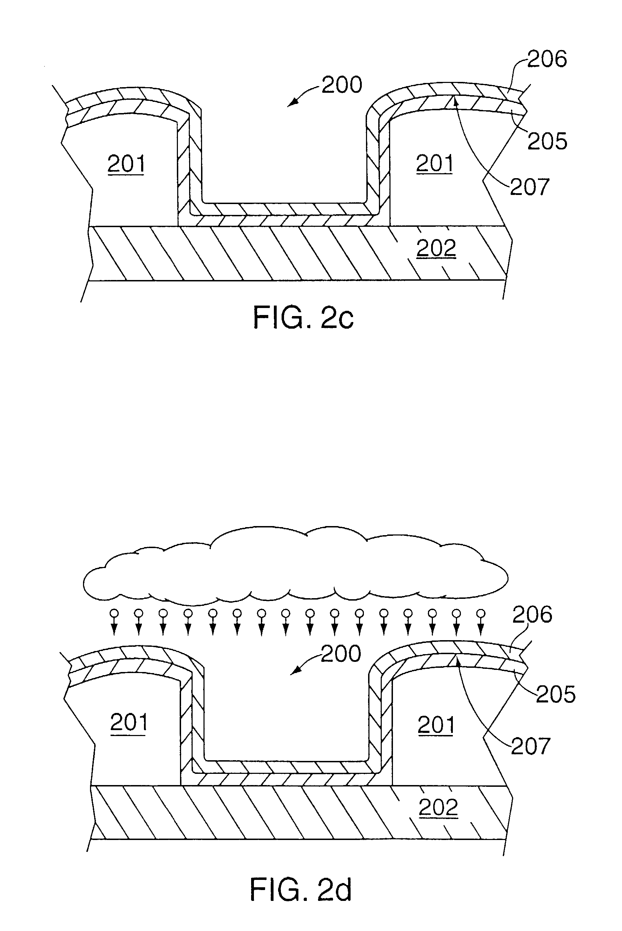

Once the first material 205 is deposited, a layer of a second material in the barrier layer is formed to overlie the first material. The layer of the second material 206, as shown in Fig. 2(c), may be deposited using traditional physical vapor deposition or chemical vapor deposition. When chemical vapor deposition is employed, the formation of the layer of the second material 206 may also include treating the second material 206 to decrease its resistivity. Plasma annealing, as shown in Fig. 2(d), may be employed to achieve this reduction in resistivity.

The layer of the second material 206 is formed to have a thickness extending from the upper surface 207 of the first material 205 within the channel 200 of less than 130 Å. In a further embodiment, the thickness of the second material is in the range of 25 to 75 Å. The combined thickness of the first material 205 and second material 206 extends from the channel's inner walls 203 for a distance of less than 400 Å. Preferably, the combined thickness of the first material 205 and second material 206 extends from the channel's inner walls 203 for a distance in the range of 75 to 175 Å.

As described above, the second material 206 is a conductive material that has an ability to form an adhesive conductive contact with a metal component of the interconnect structure. Accordingly, a metal nitride may be employed as the second material 206. Both binary metal nitrides MₓN_{y} and ternary metal silicon nitride MₓSi_{y}N_{z} (where M may be titanium, zirconium, hafnium, tantalum, molybdenum, tungsten and other metals; and x, y, and z represent different quantitative combinations of metal, silicon, and nitrogen that may be used) may be used as the metal nitride 206 in the barrier layer.

When tungsten is employed as the metal component in the interconnect structure, titanium nitride provides a good choice for the second material 206. Titanium nitride has excellent adhesion with tungsten, and serves as a good barrier to the diffusion of tungsten and by-products that are generated during the deposition of tungsten. When tungsten is deposited to form the metal component, the barrier layer is exposed to tungsten hexafluoride (WF₆). During the tungsten deposition, the fluorine is separated from the tungsten and attempts to diffuse into the barrier layer. The fluorine is highly corrosive and can result in the formation of highly resistive regions in the first material 205 of the barrier layer and the underlying conductive material 202.

Titanium nitride is well suited to inhibit the diffusion of fluorine, so that it does not reach either the first material 205 or the underlying conductive material. Traditionally, thick layers of titanium nitride in excess of 150 Å have been employed in interconnect structures to prevent diffusion. In accordance with the present invention, deposited and plasma annealed titanium nitride may be employed at thicknesses below 150 Å in the range of 25 to 75 Å.

The second material 206 may be deposited in a chamber that is capable of performing chemical vapor deposition. The chemical vapor deposition of a titanium nitride material may be achieved through the use of a metallo-organic titanium compound. One such compound is tetrakis (dialkylamido) titanium (Ti(NR₂)₄), wherein R at each occurrence independently is in an alkyl group, of, for example, 1-5 carbon atoms. It is common to use tetrakis(dimethylamido) titanium (TDMAT), which has the formula Ti(N(CH₃)₂)₄. A carrier gas, such as helium, argon, nitrogen, or hydrogen brings the compound into the CVD chamber, so that it may be infused with energy. The energy may be generated through a thermal heat source, in the case of thermal CVD, or a radio frequency ("rf") signal source, in the case of plasma enhanced CVD. The energized chemical vapor reacts with the wafer's surface to form a thin layer of material on the wafer.

When the TDMAT chemical vapor is used, a titanium nitride film is deposited on the wafer's surface. To facilitate the deposition of the titanium nitride as the second material 206, the wafer temperature is set to be in the range of 340-390°C, and the processing chamber pressure is set to be in the range of 0.5 to 2.0 Torr. A conventional CVD process for depositing titanium nitride that may be employed in embodiments of the present invention is disclosed in U.S. Patent no. 5,246,881 issued to Sandhu, et al.

However, a CVD deposited layer of the second material 206, such as titanium nitride, contains significant amounts of carbon. This causes the resulting layer of the second material 206 to be chemically reactive. Consequently, oxygen is absorbed into the film, when the film is exposed to air or other oxygen containing gases. Since the oxygen absorption is uncontrolled, the stability of the second material 206 is impaired and the resistivity of the second material 206 is adversely increased. This may result in the reliability of devices formed in the integrated circuit being poor.

After exposure to air, the sheet resistivity of a CVD deposited titanium nitride film can increase to values of about 10,000 µΩ-cm/sq up to about 100,000 µΩ-cm/sq. This is highly undesirable when the deposited titanium nitride is employed as the second material 206 in a barrier layer of an interconnect structure. A resistivity on the order of about 600 µΩ-cm or less is desirable.

As shown in Fig. 2(d), the CVD deposited second material 206 may be plasma annealed to reduce its resistivity. Either a single plasma annealing or sequential plasma annealing may be employed to reduce the resistivity of the film 206. A U.S. Patent Application entitled *Construction of a Film on a Semiconductor Wafer,* by Chern et al., filed on February 28, 1997 (with attorney docket no. 761/P6 US/CVD/KPU6/RKK) discloses both single and sequential plasma annealing processes that may be employed to reduce the resistivity of the second material 206.

In accordance with the present invention, a CVD deposited second material 206, such as titanium nitride, may be plasma annealed with an inert plasma containing high energy ions. An induced bias voltage to the wafer during rf plasma annealing provides for the ion bombardment of the wafer. When titanium nitride films that are plasma annealed in accordance with the present invention are exposed to air, oxygen, or water vapor, the oxygen is either not absorbed or absorbed to a much lesser extent than if no bias voltage had been applied to the wafer.

Titanium nitride films deposited and annealed in accordance with the present invention are also more crystalline, contain more nitrogen, and have a reduced oxygen and carbon content compared to titanium nitride films that are produced by the conventional thermal CVD of metallo-organic titanium compounds. The deposited titanium nitride films that are annealed according with the present invention also have a low and stable sheet resistivity.

The exact physical mechanism of the present invention is not known. However, it is believed that the high energy ion bombardment of the deposited material on a biased substrate densifies the film. This results in the resistance of the film being reduced and the film's ability to perform as a barrier to diffusion being increased. The reduced resistance of the second material 206 assists in providing for the formation of an interconnect structure with an acceptable resistance value. The enhanced barrier properties of the second material 206 enable the layer of the second material 206 to be thinner, thereby providing for a thin barrier layer in accordance with the present invention.

In one embodiment of the present invention, the gas used to form the plasma for the annealing of the CVD deposited second material 206 may be any gas, but is preferably a non-oxygen-and-carbon containing gas such as nitrogen, ammonia, or argon. Nitrogen is effective for passivation of a titanium nitride material. Alternatively, the deposited material can be bombarded with ions generated from a nongaseous species, such as ion sources. The plasma treatment of the deposited second material 206 does not adversely affect particle performance, step coverage, deposition rate or barrier performance of the deposited second material 206.

The above described deposition and plasma annealing of the second material 206 may be performed in any chamber or set of chambers that provides for both chemical vapor deposition and plasma annealing. However, it is beneficial if both the deposition and the plasma annealing of the second material 206 are performed in the same chamber. This eliminates the exposure of the second material 206 to contaminants, such as oxygen, during a transfer from a deposition chamber to an annealing chamber. Such exposure may cause defects, like the resistivity of the second material 206 being increased to unacceptable levels.

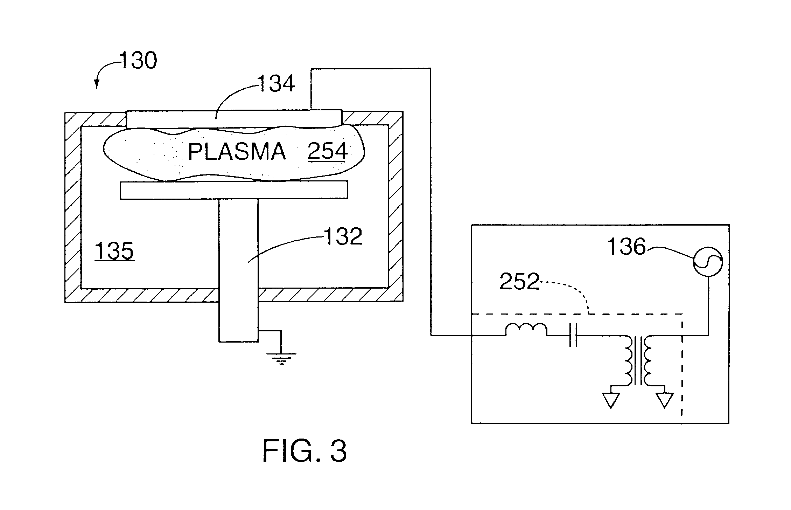

Accordingly, the CVD chamber described in U.S. Patent Application Serial No. 08/680,724, entitled *Components Peripheral to the Pedestal in the Gas Flow Path within a Chemical Vapor Deposition Chamber,* by Zhao, et al., filed on July 12, 1996, may be employed. The chamber 130 described in this application is schematically depicted in Fig. 3. The chamber 130 includes a showerhead 134 for flowing gases into a processing chamber 135 and a wafer support 132 for supporting a wafer that is being processed. The wafer support 132 is heated by a resistive coil (not shown) to set the temperature of the wafer for thermally energized reactions, such as the reactions that take place during deposition.

The wafer support 132 is grounded, and the showerhead 134 is coupled to a radio frequency ("rf") signal source 136 through a matching network 252. During plasma annealing, gas is flowed into the chamber and infused with energy from a rf signal provided by the rf signal source 136 to the showerhead 134. As a result, the gas is transformed into a plasma 254, which provides ions that bombard the wafer being supported by the wafer support 132.

A chamber provided by Applied Materials, Inc. of Santa Clara, California under the trade name TxZ Chamber may be employed to perform both the deposition and plasma annealing of the second material 206.

Alternative chambers that may be employed to perform plasma annealing in accordance with the present invention are disclosed in a U.S. Patent Application entitled *Construction of a Film on a Semiconductor Wafer,* by Chern, et al., filed on February 28, 1997 (with attorney docket number 761/P6 US/CVD/KPU6/RKK). When more than one chamber is employed to perform the CVD deposition and plasma annealing, a vacuum is preferably maintained during the transfer of the wafer from a CVD chamber to an annealing chamber.

The following procedure may be followed for performing a single plasma annealing of CVD deposited titanium nitride using nitrogen in the chamber 130 shown in Fig. 3. Although the plasma annealing process will be described with reference to the chamber 130 shown in Fig. 3, one with ordinary skill in the art will recognize that the plasma annealing may be carried out in a number of different chambers, as described above.

The wafer in which the interconnect structure is being formed is placed on the wafer support 132 and spaced about 0.3 to 0.8 inches, preferably 0.6 to 0.7 inches, from the showerhead 134. Energetic ions are obtained by applying rf energy to a nitrogen gas that is introduced into the processing chamber 135 through the showerhead 134. The rf energy is supplied from the rf signal source 136 that is coupled to the showerhead 134. An rf signal at about 350 KHz having a power of 700 to 1,000 watts is supplied.

With the rf powered showerhead 134 and the wafer support 132 and processing chamber 135 walls grounded, a DC self-bias voltage between -100 to -200 volts is induced on the wafer. Preferably, the DC self-bias voltage is in the range of -100 to -200 volts, between the wafer and ground. This is sufficient to attract ions to impact second material 206 on the wafer surface at high energy. During the plasma annealing, the pressure in the processing chamber 135 is set to be in the range of 0.5 to 2.0 Torr. As a result of the annealing, the deposited titanium nitride is passivated and densified so that it remains stable over time. The plasma annealing is performed for a time in the range of 20 to 40 seconds.

In an alternative embodiment of the present invention, a mixture of nitrogen and hydrogen may be substituted for the nitrogen during the plasma annealing of the second material 206 in the barrier layer. When employing the chamber 130 shown in Fig. 3, the wafer may be placed on the wafer support 132 and spaced about 0.3 to 0.8 inches, preferably 0.6 to 0.7 inches, from the showerhead 134.

A gas comprised of a 3:1 mixture of nitrogen and hydrogen is introduced into the processing chamber 135 via the showerhead 134. The mixture of nitrogen and hydrogen is introduced with a nitrogen flow rate of about 300 sccm. The rf source 136 then supplies 750 watts of rf power at 350 KHz through the matching network 252 to produce an rf signal to the showerhead 134.

Although the above-described gas mixture has a nitrogen to hydrogen ratio of 3:1, any ratio between 3:1 and 1:2 may be used. Generally, a higher portion of hydrogen in the mixture results in a film with greater long-term stability. However, too much hydrogen in the plasma may result in bonding between hydrogen and carbon in the film to form polymers, which increases the film's resistivity.

A plasma containing positively-charged nitrogen and hydrogen ions forms under the influence of the rf power supplied to the showerhead 134. The plasma is typically maintained for 10-35 seconds. As described above, the processing chamber walls and the wafer support 132 are grounded. The showerhead 134 acquires a negative bias between -150 to -450 volts, typically -400 volts. The wafer self-biases to acquire a negative bias of between -100 to -200 volts, typically -150 volts. This negative bias voltage remains approximately constant during a bombardment period.

During the bombardment period, positively charged ions from the plasma are accelerated by the voltage gradient into the surface of the wafer. This causes the ions to bombard the wafer surface, penetrating to a depth of 50 to 100 Å. Energetic neutral atomic particles from the plasma also may bombard the wafer.

As a result of the ion bombardment, compression of the deposited material occurs and the thickness may be reduced by 20 to 50%. The reduction depends upon the temperature of the wafer and the plasma treatment time and energy. Further layers of titanium nitride may be successively deposited and annealed as desired.

After the annealing is completed, the resulting annealed titanium nitride film exhibits many improved properties. Oxygen content is reduced from 20 to 25%, causing oxygen to comprise less than 1% of the deposited and annealed material. The density of the film increases from less than 3.1 grams per cubic centimeter (g\cm³) to about 3.9 g\cm³. The fraction of carbon incorporated into the deposited film is reduced by 25% or more, so that the carbon comprises 3% of the deposited film.

Changes in the structure of the film occur, and the film's resistivity drops from pre-treatment levels of approximately 10,000 µΩ-cm to as low as 150 µΩ-cm. When the annealed film is exposed to oxygen, air, or water vapor, oxygen is absorbed to a much lesser extent than if the deposited film were not annealed. The plasma annealing causes replacement of carbon and nitrogen in the as-deposited film with nitrogen from the plasma.

When a mixture of nitrogen and hydrogen is employed to form the plasma the following resistivities result when the second material 206 has a thickness in the following ranges: 50 Å or thinner results in a resistivity in the range of 180-210 µΩ-cm; 70 to 80 Å results in a resistivity in the range of 320 to 370 µΩ-cm; and 90 to 110 Å results in a resistivity in the range of 430 to 550 µΩ-cm.

In yet another embodiment of the present invention, the nitrogen and hydrogen gas mixture used to form an annealing plasma may also include other gases such as argon, helium, and ammonia. The inclusion of additional noble gases also improves the ion bombardment treatments. Since argon atoms are heavier than helium atoms, the argon atoms may provide superior bombardment capabilities.

In order to further reduce the resistivity of the deposited second material 206, the plasma annealing process may be altered in accordance with the present invention to include two sequential plasma annealing steps. The first annealing step is performed with a plasma that is generated from a gaseous mixture including nitrogen and hydrogen, as described above. The second plasma annealing step is performed to remove hydrogen from the annealed material, since hydrogen's affinity for oxygen results in increased resistivity.

The ions formed in the second plasma bombard the deposited and annealed material, thereby causing hydrogen in the surface of the material to be ejected from the film as a waste by-product. The reduction in hydrogen reduces the material's affinity for oxygen, which enables the film to have a lower resistivity and exhibit improved stability.

The gas used for forming the plasma in the second sequential annealing step may be comprised of nitrogen or a mixture of nitrogen and either helium, argon, or neon. Helium is preferred, since it enhances the ionization of nitrogen molecules and reduces the recombination probability of N+, N₂+, N₃+, and N₄+ ions. The mixture of nitrogen and helium is preferred over the use of nitrogen alone, since the helium based plasma's ions are able to enhance ionization efficiency, thereby promoting ion reactivity and achieving greater penetration depths. The greater penetration depths provide for the displacement of a greater amount of hydrogen, so that the reduction of the deposited material's resistivity may be maximized. Further, helium's small mass enables it to fill vacancies that are left in the deposited material by exiting hydrogen atoms which are too small to be filled by the nitrogen ions.

In accordance with the present invention, a wafer is placed in a chamber, such as chamber 130 in Fig. 3, and a layer of the second material 206 is CVD deposited on the first material 205, as described above. The deposited second material 206 may be titanium nitride.

The layer of the second material 206 then undergoes a first plasma annealing process in the same chamber 130. While residing on the wafer support 132, the wafer 114 may be about 0.3 to 0.8 inches from the showerhead 134. Preferably, the wafer is between 0.6 and 0.7 inches from the showerhead 134.

Ion bombardment is achieved by first transferring a gas into the processing chamber 135 via the showerhead 134. In one embodiment of the present invention, the gas is a mixture of nitrogen and hydrogen having a 2:3 nitrogen to hydrogen ratio and being introduced into the processing chamber 135 with a nitrogen flow rate of approximately 600 sccm. The pressure in the processing chamber 135 is set to approximately 1.0 Torr., and the wafer temperature is set to be between 350-450 °C. In an alternative embodiment of the present invention, the gas may be comprised of a mixture having a nitrogen to hydrogen ratio between 3:1 and 1:2.

Next in the first annealing process, the rf source 136 supplies a rf signal to the showerhead 134. This causes the gas to form a plasma containing positively charged ions. The rf source 136 may supply 750 watts of rf power at 350 KHz. Typically, the plasma is maintained for a period of time between 20 and 40 seconds. The rf source 136 may alternatively supply 750 watts of rf power at a frequency below 1 MHZ.

The repeated cycling of voltage from the rf source 134 results in a surplus of electrons in the vicinity of the wafer that produces a negative bias at the wafer. The showerhead 134 may acquire a negative bias between -200 to -450 volts, typically -400 volts. The processing chamber 135 and wafer support 132 are grounded, and the negative bias of the wafer is between -100 to -250 volts, typically -200 volts, which remains approximately constant during the period of ion bombardment.

During the ion bombardment, the positively charged ions from the plasma are accelerated by the voltage gradient into the surface of the wafer 114 and penetrate the surface of the wafer to a depth between 50 to 100 Å. Energetic neutral atomic particles from the plasma may also bombard the wafer. Once the first annealing is completed, the processing chamber 135 is purged.

Next, the second annealing process is initiated in the same chamber 130. In one embodiment of the present invention, the plasma generating gas is only nitrogen. The gas is introduced into the processing chamber with a nitrogen flow rate of approximately 500-1,000 sccm. The pressure in the processing chamber 135 is set to approximately 1.0 Torr., and the wafer temperature is set to be between 350-450 °C.

In an alternative embodiment of the present invention, the gas may a mixture of nitrogen and helium with a nitrogen to helium ratio between 0.2 and 1.0. Gases containing other combinations of nitrogen and either argon, neon, helium or combinations thereof may also be used.

Next in the second annealing process, the rf source 136 supplies a rf signal to the showerhead 134. This causes the gas to form a plasma containing positively charged ions. The rf source 136 may supply 300-1,500 watts of rf power at 300-400 KHz, through the matching network 252, to produce an rf signal to the showerhead 134. Typically, the plasma is maintained for a time period in the range of 20 to 40 seconds. The rf source 136 may alternatively supply 300-1,500 watts of rf power at a different frequency below 13.56 MHZ. The power of the source 136 is scalable based on the need for processing different size wafers.

As in the case of the first annealing, the repeated cycling of voltage from the rf source 136 results in a surplus of electrons in the vicinity of the wafer that produces a negative bias at the wafer. The showerhead 134 may acquire a negative bias between -200 to -450 volts, typically -400 volts. The processing chamber and wafer support 132 are grounded, and the negative bias of the wafer is between -100 to -250 volts, typically -200 volts, which remains approximately constant during a period of ion bombardment.

During the second ion bombardment, the positively charged ions from the plasma are accelerated by the voltage gradient into the surface of the wafer. The ions penetrate the surface of the second material 206 to displace the hydrogen molecules in the deposited and annealed second material 206. Energetic neutral atomic particles from the plasma may also bombard the wafer. Once the second annealing is completed, the processing chamber is purged.

When a nitrogen gas is employed in the second plasma annealing, the ions penetrate to a depth between 35 to 50 Å. When the gas is a mixture of nitrogen and helium, the ions penetrate to a depth between 50 to 100 Å. Accordingly, the annealing with the mixture of nitrogen and helium provides for the displacement of more hydrogen molecules than the annealing that only employs nitrogen.

When the sequential annealing process is performed in the chamber 130 shown in Fig. 3, the deposition, first annealing, and second annealing may all be performed in the same chamber. Accordingly, the deposition and sequential annealing may be performed *in-situ.* However, the process steps of deposition and sequential annealing are not required to be performed *in-situ,* and alternative chambers may be employed.

In order to reduce the treatment time of the above described single and sequential plasma annealing processes, the frequency and power of the signal provided by the rf source 136 may be increased. Decreasing the treatment time of the plasma annealing provides for the processing of an increased number of wafers per hour. This results in a reduced manufacturing cost for each wafer.

For example, employing the above described single annealing with a plasma containing nitrogen and hydrogen results in a wafer throughput of approximately 22.5 wafers per hour per chamber. In order to increase this throughput, the frequency of the signal provided by the rf signal source 136 may be increased to be in the range of 500 KHz to 2 MHZ, with a power of 750 watts still being provided. Alternatively, the frequency of the rf signal may be maintained in the range of 300 to 450 KHz, while the power is increased to be in the range of 750 to 1,200 watts. By employing such frequency and power adjustments, it is believed that the plasma annealing time may be reduced enough to provide a wafer throughput of 25 wafers per hour per chamber.

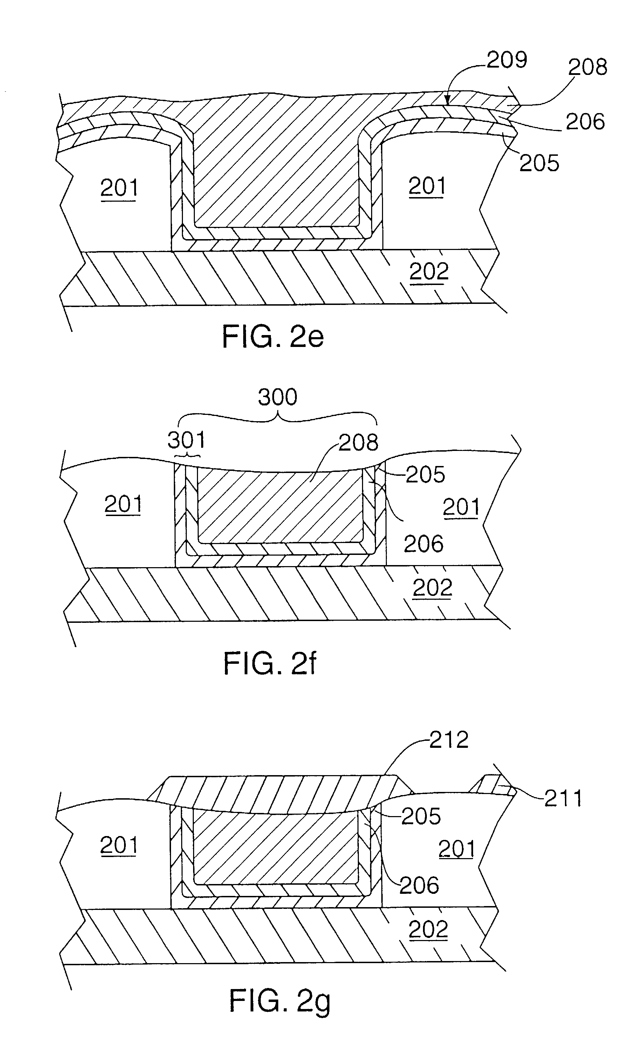

Fig. 2(e) illustrates the deposition of a conductive material 208 to serve as the metal component of the interconnect structure. A number of different metals, such as tungsten, may be employed as the conductive material 208. The conductive material 208 is deposited over the upper surface 209 of the second material 206 in the barrier layer. A number of traditional deposition techniques, such as PVD or CVD, may be employed for depositing the conductive material 208 in the interconnect structure.

Ideally, the conductive material 208 fills the remaining region in the channel 200 that is encircled by the second material 206. However, acceptable slight imperfections (not shown) may occur, so that the region encircled by the second material 206 is not completely filled. These imperfections may include small spikes that extend down from the upper surface of the conductive material 208 to only shallow depths below the channel's upper opening.

Fig. 2(f) illustrates the next step in forming the interconnect structure 300. As shown in Fig. 2(f), an isotropic etch is performed to remove the barrier layer and conductive material 208 from the surface of the insulative layer 201 that does not form the channel's inner walls 203. The first material 205, second material 206, and metal 208 remaining in the channel 200 combine to form the interconnect structure 300. The combination of the first material 205 and the second material 206 forms the barrier layer 301.

Fig. 2(g) illustrates the formation of a metal layer 211 over the insulative layer of material 201 that houses the interconnect structure. As shown in Fig. 2 (g), a conductive layer of material, such as polysilicon, aluminum, copper, or another metal, is deposited and patterned to form metal layer 211. The deposition may be achieved through PVD, CVD, or other traditional means, and the patterning may be achieved through traditional photolithography techniques. As shown in Fig. 2(g), the interconnect structure 300 is conductively coupled to a metal line 212 in metal layer 211.

The resulting interconnect structure 300 in both Fig. 2(f) and Fig. 2(g) includes a barrier layer 301, which is composed of the first material 205 and the second material 206, and a conductive material forming the metal component 208. The first material 205 provides a highly conductive connection to contact surface 204. The second material 206 is conductively coupled to the first material 205 and provides an adhesive conductive connection to the metal component 208. The metal component 208, provides a conductive lead for coupling to a metal line to provide for coupling contact surface 204 to an element in an integrated circuit.

As a result of the reduced thickness of the barrier layer 301, the width of the metal component 208 employed in the interconnect structure 300 is increased over traditional metal components in .25 µm and sub .25 µm integrated circuits. The resistance of the interconnect structure 300 is thereby reduced in comparison to the resistance of a traditional interconnect structure having a barrier layer thickness of 400-500 Å. For example, when the width W of the channel 200 is 1,000 Å and the barrier layer 301 is between 75 and 175 Å, the metal component 208 has a width ranging from 650-850 Å. This is considerably wider than the 0-200 Å width of a traditional metal component in a 1,000 Å wide channel.

Table A below shows the resistance values for different interconnect structures formed in accordance with the present invention. In Table A, each row corresponds to a recipe for forming an interconnect structure in accordance with the present invention. Each interconnect structure was formed in a channel having a width in the range of 0.40 to 0.25 µm and an aspect ratio in the range of 3.5 to 4.5.

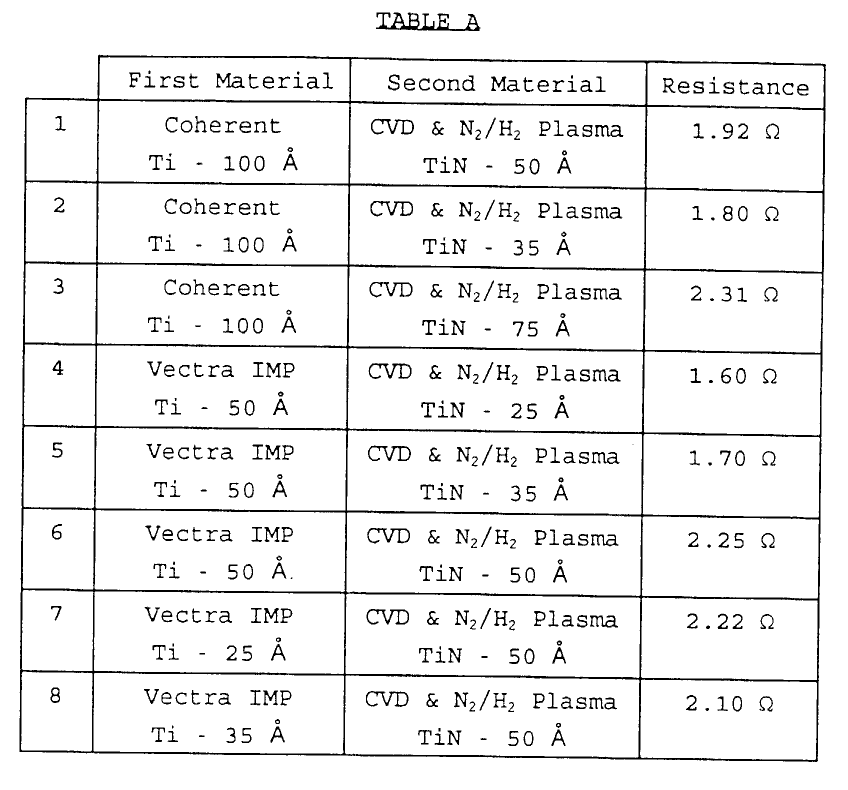

The First Material column indicates the process that was used to deposit the layer of the first material 205 in the barrier layer 301 of each interconnect structure. This column also indicates the material used for the first material 205 and the thickness of the first material 205.

Similarly, the Second Material column indicates the deposition and plasma annealing processes employed in the formation of the layer of the second material 206 in the barrier layer 301. This column also indicates the material employed for the second material 206 and the thickness of the second material 206. The Resistance column indicates the resistance value for an interconnect structure formed in accordance with each recipe.

For example, the interconnect structure formed in accordance with the recipe set forth in row 1 employs titanium for the first material 205 and titanium nitride for the second material 206. The layer of titanium is PVD deposited to have a thickness of 100 Å using the chamber that performs the Coherent process. The layer of titanium nitride is formed by CVD depositing titanium nitride and then single plasma annealing the titanium nitride in a plasma composed of a mixture of nitrogen and hydrogen. After deposition and plasma annealing, the thickness of the titanium nitride is 50 Å.

The resistance of the interconnect structured that is formed according the recipe in row 1 is equal to 1.92 Ω, which is well below the maximum allowable value of 3.0 Q. In fact, all of the recipes shown in rows 1-8 provide for the formation of interconnect structures with resistance values of less than 3.0 Ω. This is a result of the thin barrier layers that are formed by the first material 205 and the second material 206.

All of the barrier layers provided for by the recipes shown in rows 1-8 fall within the range of 75 to 175 Å. When barrier layers having these thicknesses are employed instead of barrier layers with traditional thicknesses of 400-500 Å, wider lower resistance metal components can be formed. As a result, interconnect structures in accordance with the present invention have lower resistance values than traditionally formed interconnect structures.

In general, interconnect structures formed in accordance with the present invention have been found to have acceptable resistance values in integrated circuits with gate lengths in the range of .25 µm and less. In particular, in integrated circuits with gate lengths between .25 µm and .18 µm, acceptable interconnect structures have been formed in accordance with the present invention by employing the following first materials 205: Coherent deposited titanium having thicknesses in the range of 50 to 100 Å; Vectra IMP deposited titanium having thicknesses in the range of 40-60 Å; or CVD deposited titanium having thicknesses in the range of 40 to 60 Å. Deposited and plasma annealed titanium nitride having thicknesses in the range of 25 to 100 A has served as an acceptable second material 206 in barrier layers for integrated circuits employing .25 µm and .18 µm gate lengths. The above listed first material and second material dimensions have been found to be particularly effective when employed to conductively couple salicide surfaces and metal lines.

Even though the present invention has been described with respect to its utility in integrated circuits that are constructed using .25 µm and sub .25 µm technology, the present invention is not limited to implementations in such integrated circuits. Interconnect structures in accordance with the present invention may also be formed in integrated circuits built in larger technologies to reduce contact and via resistance. Further, the reduced thickness of a barrier layer formed in accordance with the present invention results in less material being deposited during the barrier layer's formation. The reduced volume of deposition for each barrier layer allows more barrier layers to be formed in a single chamber in between chamber cleanings. This reduces the cost of maintaining the chamber, thereby reducing the cost of processing wafers in the chamber.

Although the present invention has been described in terms of specific exemplary embodiments, it will be appreciated that various modifications and alterations might be made by those skilled in the art without departing from the spirit and scope of the invention as specified in the following claims.

## Claims

1. A structure in an integrated circuit, said structure extending from a conductive surface through a channel having inner walls extending above said conductive surface, said structure comprising:
a layer of a refractory metal residing on said conductive surface and said inner walls of said channel; and
a layer of a metal nitride residing on said layer of said refractory metal, wherein said layer of said metal nitride has a thickness extending from said layer of said refractory metal of less than 130 Å.

2. A structure as claimed in claim 1, wherein said structure has a width that is less than or equal to 3,000 Å.

3. A structure as claimed in claim 1 or claim 2, wherein a ratio of a height of said structure to a width of said structure is greater than or equal to 3.33.

4. A structure as claimed in any one of claims 1 to 3, wherein said layer of said refractory metal has a thickness extending from said inner walls of said channel in a range of from 25 to 100 Å.

5. A structure as claimed in any one of claims 1 to 4, wherein said metal nitride has a resistivity of less than 600 µΩ-cm.

6. A structure as claimed in any one of claims 1 to 5, further including:
a layer of a metal residing on said layer of said metal nitride, wherein said metal nitride is preferably adhesive to said metal, and wherein said metal is preferably tungsten.

7. A structure as claimed in any one of claims 1 to 6, wherein said structure has a resistance less than or equal to 3.0 Ω.

8. A structure in an integrated circuit, said structure extending from a conductive surface surrounded by a channel having inner walls extending from said conductive surface, said structure comprising:
a layer of a refractory metal having a thickness in a range of from 25 to 100 Å residing on said conductive surface and said inner walls of said channel; and
a layer of a metal nitride residing on said layer of said refractory metal, wherein said layer of said metal nitride has a thickness extending from said layer of said refractory metal of less than 130 Å.

9. A structure as claimed in any one of claims 1 to 8, wherein said layer of said metal nitride has a thickness in the range of from 25 to 75 Å.

10. A structure as claimed in any one of claims 1 to 9, wherein said layer of said refractory metal and said layer of said metal nitride have a combined thickness extending from said inner walls of said channel of less than 200 Å, preferably less than 175 Å.

11. A structure as claimed in any one of claims 1 to 10, wherein said channel has an aspect ratio greater than or equal to 3.33.

12. A structure as claimed in any one of claims 1 to 11, wherein said refractory metal is selected from titanium, tantalum, cobalt and molybdenum.

13. A structure as claimed in any one of claims 1 to 12, wherein said metal nitride includes a metal selected from titanium, zirconium, hafnium, tantalum, molybdenum and tungsten.

14. A method for forming a structure in an integrated circuit, said structure extending from a conductive surface through a channel having inner walls extending above said conductive surface, said method including the steps of:
(a) depositing a layer of a refractory metal on said conductive surface and said inner walls of said channel; and
(b) forming a layer of a metal nitride on said layer of said refractory metal, wherein said layer of said metal nitride has a thickness extending from said layer of said refractory metal of less than 130 Å.

15. A method as claimed in claim 14, wherein said layer of said metal nitride has a thickness in the range of from 25 to 75 Å.

16. A method as claimed in claim 14 or claim 15, wherein said layer of said refractory metal and said layer of said metal nitride have a combined thickness extending from said inner walls of said channel of less than 200 Å.

17. A method as claimed in any one of claims 14 to 16, wherein said step (b) includes the steps of:
depositing said metal nitride on said layer of said refractory metal; and
plasma annealing said metal nitride.

18. A method as claimed in any one of claims 14 to 17, wherein said step of plasma annealing includes the steps of:
exposing said metal nitride to an environment containing ions; and
electrically biasing said layer of said metal nitride to cause said ions from said environment to impact said metal nitride.

19. A method as claimed in claim 18, wherein said step of exposing said metal nitride to said environment containing ions incudes the steps of:
providing a gas; and
providing a first rf signal to a first electrode on a first side of a wafer on which said structure is being formed to provide energy to said gas.

20. A method as claimed in claim 19, wherein said gas contains at least one gas selected from nitrogen, hydrogen, argon, helium and ammonia or wherein said gas includes a noble gas.

21. A method as claimed in claim 17, wherein said step of plasma annealing includes the steps of:
performing a first plasma annealing of said metal nitride; and
performing a second plasma annealing of said metal nitride after performing said first plasma annealing.

22. A method as claimed in claim 21, wherein said step of performing said first plasma annealing includes the steps of:
exposing said metal nitride to a first environment containing ions; and
electrically biasing said metal nitride to cause said ions from said first environment to impact said metal nitride.

23. A method as claimed in claim 22, wherein said step of performing said second plasma annealing includes the steps of:
exposing said metal nitride to a second environment containing ions; and
electrically biasing said metal nitride to cause said ions from said second environment to impact said layer of said metal nitride.

24. A method as claimed in claim 23, wherein said step of exposing said metal nitride to a first environment containing ions includes the steps of:
providing a first gas, and
providing energy to said first gas to generate a first plasma, and
wherein said step of exposing said metal nitride to a second environment containing ions includes the steps of:
providing a second gas, and
providing energy to said second gas to generate a second plasma.

25. A method as claimed in claim 24, wherein said first gas contains at least one gas selected from nitrogen, hydrogen, argon, helium and ammonia, and/or wherein said second gas contains at least one gas selected from nitrogen, helium, neon and argon.

26. A method as claimed in any one of claims 17 to 25, wherein said step of depositing said metal nitride is performed using chemical vapor deposition.

27. A method as claimed in any one of claims 17 to 26, wherein said step of depositing said metal nitride and said step of plasma annealing are both performed in a chamber without removing a wafer on which said structure is being formed from the chamber between initiating said step of depositing said metal nitride and completing said step of plasma annealing.

28. A method as claimed in any one of claims 14 to 27, wherein said refractory metal is deposited in said step (a) by physical vapor deposition or chemical vapor deposition.

29. A method as claimed in claim 28, wherein said refractory metal is selected from titanium, tantalum, cobalt and molybdenum.

30. A method as claimed in any one of claims 14 to 29, further including the step following said step (b) of:
(c) depositing a layer of a metal on said layer of said metal nitride, wherein said metal is preferably tungsten.

31. A method as claimed in claim 30, further including the step following said step (c) of:
(d) etching said layer of said refractory metal, said layer of said metal nitride and said layer of said metal to decompose portions of said layer of said refractory metal, said layer of said metal nitride and said layer of said metal that reside outside of said channel.

32. A method for forming a barrier layer over a conductive surface surrounded by a channel having inner walls extending above said conductive surface, said method including the steps of:
(a) depositing a layer of a refractory metal on said conductive surface and said inner walls of said channel to a thickness in a range of from 25 to 100 Å;
(b) depositing a layer of a metal nitride on said layer of said refractory metal; and
(c) plasma annealing said layer of said metal nitride, wherein said layer of said metal nitride has a thickness extending from said layer of said refractory metal of less than 130 Å after completing said step (c).

33. A method as claimed in claim 32, wherein said step (c) includes the steps of:
providing a gas;
providing energy to said gas to generate an environment containing ions; and
electrically biasing said metal nitride to cause said ions from said environment to impact said metal nitride.

34. A method as claimed in any one of claims 14 to 33, wherein said metal nitride includes at least one material selected from titanium, tantalum, tungsten, hafnium, molybdenum and zirconium.

35. A method as claimed in claim 32, wherein said step (c) includes the steps of:
performing a first plasma annealing of said metal nitride; and
performing a second plasma annealing of said metal nitride after performing said first plasma annealing.

36. A method as claimed in any one of claims 14 to 35, wherein said channel has a width less than or equal to 3,000 Å.

37. A method as claimed in any one of claims 14 to 36, wherein said channel has an aspect ratio that is greater than or equal to 3.33.
